# EUROPÄISCHE PATENTSCHRIFT

(11) **EP 0 819 369 B1**
(45) Veröffentlichungstag und Bekanntmachung des Hinweises auf die Patenterteilung: **20.01.1999**
(21) Anmeldenummer: 96910000.7
(22) Anmeldetag: 20.03.1996
(51) Int. Cl.: H05K 9/00, H05K 7/20, B01D 46/10

(54) **FILTEREINRICHTUNG MIT EINEM FILTERGEHÄUSE, EINER FILTERMATTE UND EINEM LAMELLENGITTER**
FILTERING DEVICE WITH A FILTER HOUSING, A FILTER MAT AND A LAMELLA GRID
DISPOSITIF FILTRANT COMPORTANT UN CORPS, UN MAT ET UNE GRILLE LAMELLAIRE

(30) Priorität: 01.04.1995 DE 19512326
(43) Veröffentlichungstag der Anmeldung: 21.01.1998
(73) Patentinhaber: Rittal-Werk Rudolf Loh GmbH & Co. KG, 35745 Herborn (DE)
(72) Erfinder: NICOLAI, Walter, D-35418 Buseck (DE); PAWLOWSKI, Adam, D-35713 Eschenburg-Wissenbach (DE); SCHULER, Wolfgang, D-35630 Ehringshausen (DE); STRACKBEIN, Heinrich, D-35444 Biebertal (DE)
(74) Vertreter: Fleck, Hermann-Josef, Dr.-Ing.
(86) Internationale Anmeldenummer: EP9601199
(87) Internationale Veröffentlichungsnummer: WO9631999

(56) Entgegenhaltungen:
- EP-A- 0 162 960
- EP-A- 0 397 616
- EP-A- 0 413 518
- DE-C- 4 312 664
- US-A- 3 446 906

## Beschreibung

Die Erfindung betrifft eine Filtereinrichtung mit einem Filtergehäuse, das eine Filtermatte aufnimmt, auf der Austrittsseite mit einem Lamellengitter abgedeckt ist und in einen Durchbruch einer Montagewand eingesetzt ist.

Eine derartige Filtereinrichtung, wie sie z.B. aus der DE-C-4 312 664 bekannt ist, besitzt den Vorteil, daß sie im Aufbau im wesentlichen gleich ist, ob sie mit oder ohne einen Ventilator aufgebaut ist. In beiden Fällen ist jedoch keine HF-Abschirmung gegeben. Dies ist jedoch in vielen Anwendungsfällen erforderlich, es sei nur an den Einsatz in empfindlichen und störanfälligen, elektronischen Geräten erinnert.

Es ist daher Aufgabe der Erfindung, eine Filtereinrichtung der eingangs erwähnten Art ohne wesentliche Änderung des Aufbaues HF-dicht auszuführen.

Diese Aufgabe wird nach der Erfindung dadurch gelöst, daß die Oberfläche des Filtergehäuses elektrisch leitend ist und daß die Oberfläche des Filtergehäuses elektrisch leitend ist und mittels eines elektrisch leitenden Kontakt rahmens in den Durchbruch der Montageplatte eingesetzt ist, wobei der Kontaktrahmen an mehreren Stellen elektrisch leitend mit dem Filtergehäuse und dem Durchbruch der Montageplatte in elektrisch leitender Verbindung steht, und daß in das Filtergehäuse oder zwischen Filtergehäuse und einem mit dem Filtergehäuse verbindbaren Ventilator ein elektrisch leitendes Schirmgitter eingesetzt oder angeordnet ist.

Die konstruktive Ausgestaltung der Teile der Filtereinrichtung kann praktisch unverändert bleiben. Dies wird allein durch die Oberflächengestaltung und die Materialwahl für bestimmte Teile, wie das Filtergehäuse, das Schirmgitter und einen Kontaktrahmen, erreicht. Bei der Verwendung eines Ventilators ändert sich lediglich das Filtergehäuse.

Die elektrisch leitende Oberfläche für das Filtergehäuse wird nach einer Ausgestaltung durch eine elektrisch leitende Bedampfung erreicht.

In jedem Fall ist das Filtergehäuse so ausgebildet, daß es auf der Austrittsseite eine Aufnahme für die Filtermatte und das Schirmgitter bildet und mit dem Lamellengitter abgedeckt ist.

Für die Montage ist nach einer Ausgestaltung vorgesehen, daß das Filtergehäuse einen umlaufenden Befestigungsflansch mit Befestigungsbohrungen aufweist und mittels Schrauben unter Zwischenlage eines Befestigungsflansches des Kontaktrahmens mit einer Kontaktierungsfläche des Montagebleches verschraubt ist.

Die Kontaktgabe zwischen Kontaktrahmen und Montageblech wird dadurch verbessert, daß das Montageblech im Bereich des Befestigungsflansches des Kontaktrahmens mit einer um den Durchbruch angeordneten Kontaktierungsfläche mit Schraubaufnahmen oder Befestigungsbohrungen versehen ist.

Nach einer Ausgestaltung ist vorgesehen, daß die Eintrittsseite des Filtergehäuses mittels eines grobmaschigen Haltegitters abgedeckt ist und das eingesetzte Schirmgitter und die Filtermatte hält. Das Haltegitter ist dabei vorzugsweise einstückig mit dem Filtergehäuse ausgebildet.

Bei einer Ausgestaltung mit Ventilator ist vorgesehen, daß der Ventilator mit der Eintrittsseite des Filtergehäuses verschraubt ist und daß die Eintrittsseite des Ventilators mit einem Schutzgitter abgedeckt ist.

Der Kontaktrahmen ist für eine ausgezeichnete Kontaktgabe mit dem eingesetzten Filtergehäuse und dem Montageblech so ausgebildet, daß der Kontaktrahmen mit einer Vielzahl von Kontaktfedern in den Durchbruch des Montage bleches ragt, die schräg gestellt mit der einen Kante Kontaktstellen im Durchbruch und mit der anderen Kante Kontaktstellen mit dem Filtergehäuse bilden.

Die HF-Abschirmung kann beim Einsatz eines Ventilators auch dadurch erreicht werden, daß das Schirmgitter zwischen dem Filtergehäuse und dem Ventilator angeordnet ist.

Der mit dem Filtergehäuse verbundene Ventilator ragt durch den Kontaktrahmen und den Durchbruch des Montagebleches.

Die Erfindung wird anhand von in den Zeichnungen dargestellten Ausführungsbeispielen näher erläutert. Es zeigen jeweils in Explosionsdarstellung:
- **Fig. 1**: eine Filtereinrichtung ohne Ventilator und
- **Fig. 2**: eine Filtereinrichtung mit einem Ventilator.

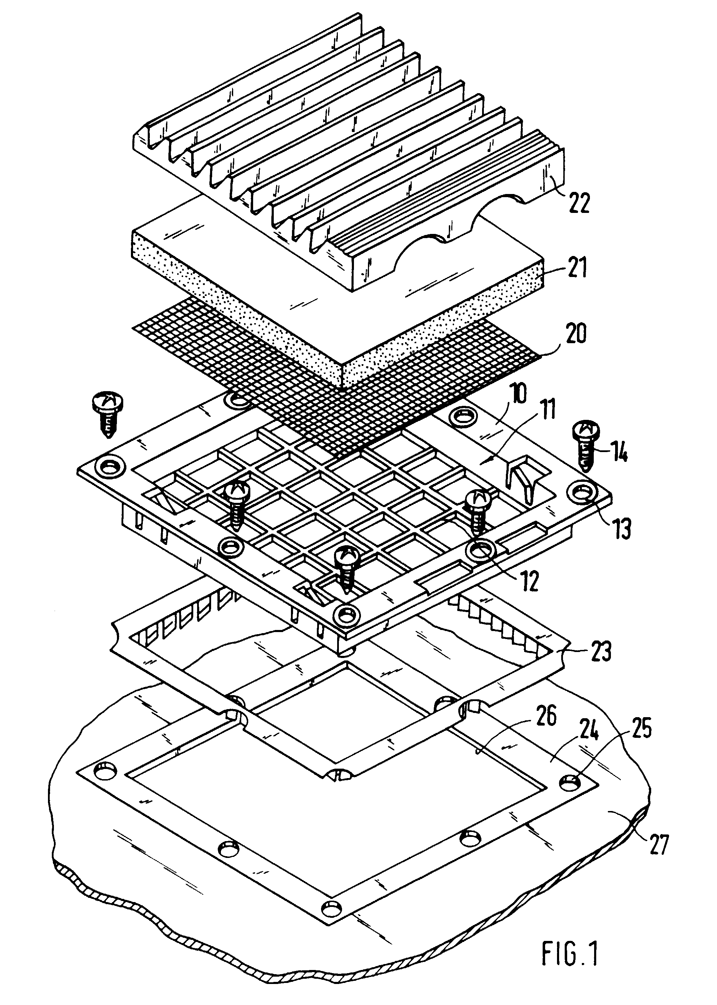

Wie Fig. 1 zeigt, weist ein Montageblech 27, z.B. eine Gerätewand eines Schaltschrankes, einen Durchbruch 26 auf, der von einer Kontaktierungsfläche 24 mit Schraubaufnahmen 25 oder Befestigungsbohrungen umgeben ist. In den Durchbruch 26 wird ein Kontaktrahmen 23 eingesetzt, der aus elektrisch leitendem Material besteht und mit einem Befestigungsflansch mit der Kontaktierungsfläche 24 in elektrisch leitende Verbindung gebracht werden kann, wenn ein Filtergehäuse 10 mittels der Schrauben 14 über die Befestigungsbohrungen 13 seines Befestigungsflansches mit den Schraubaufnahmen 25 verschraubt wird. Das Filtergehäuse 10 besteht aus Kunststoff und seine Oberfläche ist durch Bedampfung mit einem elektrisch leitenden Belag versehen, so daß das Filtergehäuse 10 und der Kontaktrahmen 23 elektrisch leitend miteinander verbunden sind. Der Kontaktrahmen 23 ragt mit einer Vielzahl von schräg gestellten Kontaktfedern in den Durchbruch 26, die mit den einen Kanten Kontaktstellen mit dem Durchbruch 26 und mit den anderen Kanten mit dem eingeführten Absatz des Filtergehäuses 10 bilden.

Der Kontaktrahmen 23 besteht aus elektrisch leitendem Material. Er kann auch aus Kunststoff bestehen und elektrisch leitend bedampft sein.

Auf der Austrittsseite bildet das Filtergehäuse 10 eine Aufnahme 11, in die nacheinander ein Schirmgitter 20 und eine Filtermatte 21 eingebracht werden. Gehalten werden diese Teile durch ein Haltegitter 12, das grobmaschig und vorzugsweise einstückig mit dem Filtergehäuse 10 ausgebildet ist. Ein Lamellengitter 22 deckt die Austrittsseite der Filtereinrichtung in bekannter Weise ab. Für den Kontaktrahmen 23, der ebenfalls die HF-Abschirmung unterstützt, wird nach einer Ausgestaltung Kupfer-Berylium verwendet. Der Durchbruch 26 im Montageblech 27 ist damit HF-mäßig dicht gemacht, d.h. die Filtereinrichtung im Durchbruch 26 ist zum Montageblech 27 hin HF-mäßig abgeschirmt.

Ist in die Filtereinrichtung ein Ventilator 16 einbezogen, dann ist lediglich das Filtergehäuse 10' mit seiner Aufnahme 11' anders gestaltet. Auf der Austrittsseite desselben ist wieder eine Filtermatte 21 eingesetzt und ein Lamellengitter 22 als Abdeckung verwendet. Das Montageblech 27 mit dem Durchbruch 26 und der Kontaktierungsfläche 24 mit den Schraubaufnahmen 25 bleiben unverändert. Die Befestigung des Filtergehäuses 10' an dem Montageblech 27 mit den Schrauben 14 bleibt ebenfalls unverändert. Auf der Eintrittsseite des Filtergehäuses 10' ist ein Ventilator 15 unter Zwischenlage eines Schirmgitters 20 angeschraubt, wobei Schrauben 17 in Schraubaufnahmen 16 eines Befestigungsflansches des Ventilators 15 eingeschraubt werden. Der Ventilator 15 ragt durch den Kontaktrahmen 23 und den Durchbruch 26 des Montagebleches 27. Der Kontaktrahmen 23, das Schirmgitter 20 und das mit einer elektrisch leitenden Oberfläche versehene Filtergehäuse 10' schließen den Durchbruch 26 wieder HF-dicht ab. Das Schirmgitter 20 ist feinmaschiger als das Haltegitter 12 der Filtereinrichtung nach Fig. 1 und auch feinmaschiger als ein mit der Austrittsseite des Ventilators 15 verbundenes Schutzgitter 18, welches mittels Schrauben 19 mit dem Ventilator 15 verbunden ist.

Die Kontaktierungsfläche 24 kann auf das Montageblech 27 aufgebracht sein. Es kann jedoch auch ein von dem Montageblech 27 getrenntes Teil sein, das in den Durchbruch 26 des Montagebleches 27 eingesetzt und elektrisch leitend mit diesem verbunden sein kann. Die elektrische Leitfähigkeit der Oberfläche des Filtergehäuses 10 bzw. 10' und eines Kunststoff-Kontaktrahmens 23 kann auch in anderer Weise wie durch Bedampfung erzielt werden.

Auch das elektrisch leitende Schirmgitter 20 kann aus Kunststoff bestehen und mit einer elektrisch leitenden Oberfläche versehen sein.

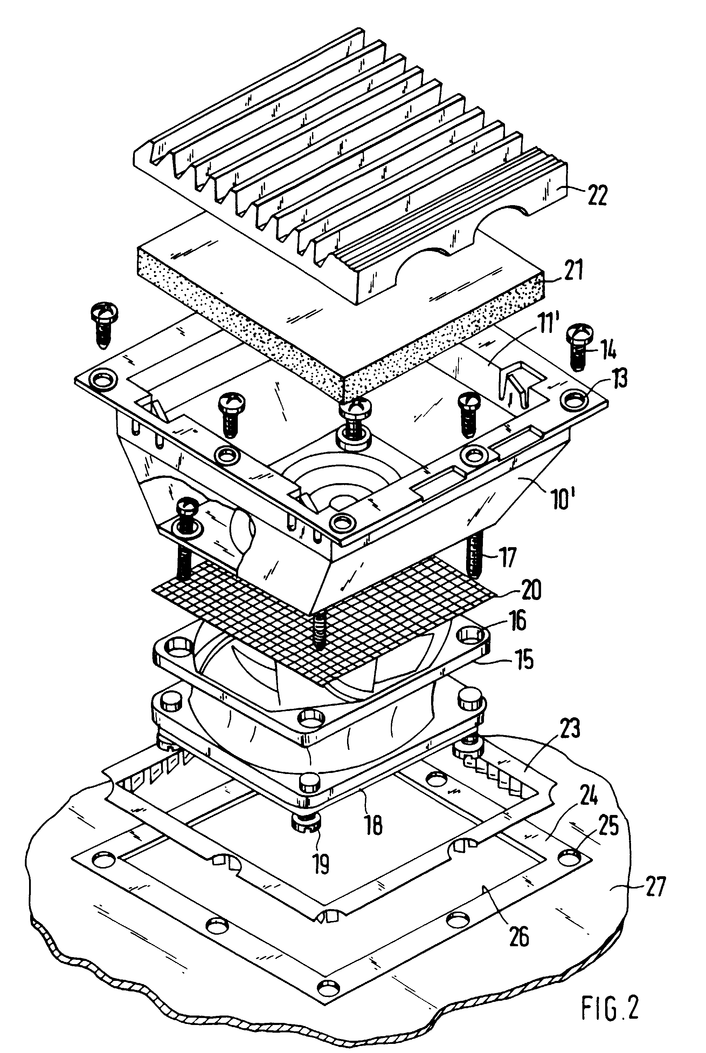

Der Grundaufbau der Filtereinrichtung ohne Ventilator nach Fig. 1 und der Filtereinrichtung mit Ventilator 15 nach Fig. 2 bleibt im wesentlichen beibehalten.

Es wird stets eine vollständige HF-Abschirmung des Durchbruches 26 des Montagebleches 27 erreicht,da das Montageblech 27, der Kontaktrahmen 23 und das Filtergehäuse 10 bzw. 10' mit dem Schirmgitter 20 elektrisch leitend verbunden sind und den Durchbruch 26 elektrisch leitend überdecken und abschirmen.

## Patentansprüche

1. Filtereinrichtung mit einem Filtergehäuse, das eine Filtermatte aufnimmt, auf der Austrittsseite mit einem Lamellengitter abgedeckt ist und in einen Durchbruch einer Montagewand eingesetzt ist,
dadurch gekennzeichnet,
daß die Oberfläche des Filtergehäuses (10,10') elektrisch leitend ist und mittels eines elektrisch leitenden Kontaktrahmens (23) in den Durchbruch (26) der Montageplatte (27) eingesetzt ist, wobei der Kontaktrahmen (23) an mehreren Stellen elektrisch leitend mit dem Filtergehäuse (10,10') und dem Durchbruch (26) der Montageplatte (27) in elektrisch leitender Verbindung steht, und
daß in das Filtergehäuse (10) oder zwischen Filtergehäuse (10') und einem mit dem Filtergehäuse (10') verbindbaren Ventilator (15) ein elektrisch leitendes Schirmgitter (20) eingesetzt oder angeordnet ist.

2. Filtereinrichtung nach Anspruch 1,
dadurch gekennzeichnet,
daß das Filtergehäuse (10,10') aus Kunststoff besteht und elektrisch leitend bedampft ist.

3. Filtereinrichtung nach Anspruch 1 oder 2,
dadurch gekennzeichnet,
daß das Filtergehäuse (10,10') auf der Austrittsseite eine Aufnahme (11,11') bildet, in die die Filtermatte (21) und das Schirmgitter (20) eingebracht sind.

4. Filtereinrichtung nach einem der Ansprüche 1 bis 3,
dadurch gekennzeichnet,
daß das Filtergehäuse (10,10') einen umlaufenden Befestigungsflansch mit Befestigungsbohrungen (12) aufweist und mittels Schrauben (14) unter Zwischenlage eines Befestigungsflansches des Kontaktrahmens (23) mit dem Montageblech (27) verschraubt ist.

5. Filtereinrichtung nach Anspruch 4,
dadurch gekennzeichnet,
daß das Montage blech (27) im Bereich des Befestigungsflansches des Kontaktrahmens (23) mit einer um den Durchbruch (26) angeordneten Kontaktierungsfläche (24) mit Schraubaufnahmen (26) oder Befesitgungsbohrungen versehen ist.

6. Filtereinrichtung nach einem der Ansprüche 1 bis 5,
dadurch gekennzeichnet,
daß die Eintrittsseite des Filtergehäuses (10) mittels eines grobmaschigen Haltegitters (12) abgedeckt ist und das eingesetzte Schirmgitter (20) und die Filtermatte (21) hält.

7. Filtereinrichtung nach Anspruch 6,
dadurch gekennzeichnet,
daß das Haltegitter (12) einstückig mit dem Filtergehäuse (10) ausgebildet ist.

8. Filtereinrichtung nach einem der Ansprüche 1 bis 7,
dadurch gekennzeichnet,
daß die Eintrittsseite des Ventilators (15) mittels eines Schutzgitters (18) abgedeckt ist.

9. Filtereinrichtung nach einem der Ansprüche 1 bis 8,
dadurch gekennzeichnet,
daß der Kontaktrahmen (23) mit einer Vielzahl von Kontaktfedern in den Durchbruch (26) des Montagebleches (27) ragt, die schräg gestellt mit der einen Kante Kontaktstellen im Durchbruch und mit der anderen Kante Kontaktstellen mit dem Filtergehäuse (10,10') bilden.

10. Filtereinrichtung nach einem der Ansprüche 1 bis 9,
dadurch gekennzeichnet,
daß der Ventilator (15) durch den Kontaktrahmen (23) und den Durchbruch (26) des Montagebleches (27) ragt.

## Claims

1. Filter arrangement, having a filter housing which accommodates a filter mat, is covered with a laminar lattice on the outlet side and is inserted in an opening in a mounting wall, characterised in that the surface of the filter housing (10,10') is electrically conductive and inserted in the opening (26) in the mounting plate (27) by means of an electrically conductive contact frame (23), the contact frame (23) communicating electrically conductively with the filter housing (10,10') and the opening (26) in the mounting plate (27) at a plurality of locations, and in that an electrically conductive screen grid (20) is inserted or disposed in the filter housing (10) or between the filter housing (10') and a fan (15), which is connectable to the filter housing (10').

2. Filter arrangement according to claim 1, characterised in that the filter housing (10,10') is formed from plastics material and is vapour-deposited in an electrically conductive manner.

3. Filter arrangement according to claim 1 or 2, characterised in that the filter housing (10,10') forms a receiver (11,11') on the outlet side, and the filter mat (21) and the screen grid (20) are introduced into said receiver.

4. Filter arrangement according to one of claims 1 to 3, characterised in that the filter housing (10,10') has a mounting flange extending all-round and provided with mounting bores (12), and said housing is screw-connected to the mounting plate (27) by means of screws (14) with the interposition of a mounting flange of the contact frame (23).

5. Filter arrangement according to claim 4, characterised in that, in the region of the mounting flange of the contact frame (23), the mounting plate (27) is provided with a contacting face (24), which is disposed around the opening (26) and is provided with screw receivers (25) or mounting bores.

6. Filter arrangement according to one of claims 1 to 5, characterised in that the inlet side of the filter housing (10) is covered by means of a wide-meshed retaining grid (12) and retains the inserted screen grid (20) and the filter mat (21).

7. Filter arrangement according to claim 6, characterised in that the retaining grid (12) is integral with the filter housing (10).

8. Filter arrangement according to one of claims 1 to 7, characterised in that the inlet side of the fan (15) is covered by means of a protective grid (18).

9. Filter arrangement according to one of claims 1 to 8, characterised in that the contact frame (23) protrudes into the opening (26) in the mounting plate (27) with a plurality of contact springs which, when inclinedly positioned, form points of contact in the opening with one edge and points of contact with the filter housing (10,10') with the other edge.

10. Filter arrangement according to one of claims 1 to 9, characterised in that the fan (15) protrudes through the contact frame (23) and the opening (26) in the mounting plate (27).

## Revendications

1. Dispositif filtrant comportant un corps qui reçoit un mat filtrant, qui du côté sortie est recouvert par une grille-écran et qui est monté dans un percement d'une paroi de montage,
caractérisé
en ce que la surface du corps (10, 10') est à conductivité électrique et est par l'intermédiaire d'un cadre de contact (23) conducteur électrique monté dans le percement (26) de la plaque de montage (27), le cadre de contact (23) étant en plusieurs points en connexion, électrique avec le corps (10, 10') et avec le percement (26) de la plaque de montage, et
en ce que dans le corps (10) du dispositif filtrant ou bien entre le corps (10)' et un ventilateur (15) pouvant être relié au corps (10') est montée ou disposée une grille-écran (20) conductrice électrique.

2. Dispositif filtrant suivant la revendication 1,
caractérisé
en ce que le corps (10, 10') du dispositif filtrant est en matière plastique et est revêtu par vaporisation d'une couche conductrice électrique.

3. Dispositif filtrant suivant la revendication 1 ou 2,
caractérisé
en ce que du côté sortie, le corps (10, 10') du dispositif filtrant constitue un logement (11, 11') dans lequel sont placés le mat filtrant (21) et la grille-écran (20).

4. Dispositif filtrant suivant l'une quelconque des revendications de 1 à 3,
caractérisé
en ce que le corps (10, 10') du dispositif filtrant présente une bride de fixation périphérique avec des forures de fixation (12) et est au moyen de vis avec interposition d'une bride de fixation du cadre de contact (23) vissé sur la tôle de montage (27).

5. Dispositif filtrant suivant la revendication 4,
caractérisé
en ce que dans la région de la bride de fixation du cadre de contact (23), la tôle de montage (27) est dotée d'une surface de contact (24) disposée autour du percement (26) et présentant des logements (26) pour vis ou des forures de fixation.

6. Dispositif filtrant suivant l'une quelconque des revendications de 1 à 5,
caractérisé
en ce que le côté admission du corps (10) est recouvert d'une grille de retenue à grosses mailles (12) qui retient la grille-écran (20) mise en place et le mat filtrant (21).

7. Dispositif filtrant suivant la revendication 6,
caractérisé
en ce que la grille de retenue (12) forme une pièce avec le corps du dispositif filtrant (10) et en fait partie intégrante.

8. Dispositif filtrant suivant l'une quelconque des revendications de 1 à 7,
caractérisé
en ce que le côté admission du ventilateur (15) est recouvert d'une grille de protection (18).

9. Dispositif filtrant suivant l'une quelconque des revendications de 1 à 8,
caractérisé
en ce que la cadre de contact (23) s'engage par une multiplicité de lames de contact dans le percement (26) de la tôle de montage (27), lames qui disposées en oblique constituent par une arête des points de contact dans le percement et qui par l'autre arête constituent des points de contact avec le corps du dispositif filtrant (10, 10').

10. Dispositif filtrant suivant l'une quelconque des revendications de 1 à 9,
caractérisé
en ce que le ventilateur (15) passe au travers le cadre de contact (23) et au travers le percement (26) de la tôle de montage (27).
